# EUROPEAN PATENT SPECIFICATION

(11) **EP 0 762 513 B1**
(45) Date of publication and mention of the grant of the patent: **02.04.2003**
(21) Application number: 96113821.1
(22) Date of filing: 22.08.1996
(51) Int. Cl.: H01L 31/042

(54) **Solar cell module and method for manufacturing the same**
Solarzellemodul und Verfahren zu seiner Herstellung
Module de cellules solaires et procédé de fabrication

(30) Priority: 23.08.1995 JP 21505295
(43) Date of publication of application: 12.03.1997
(73) Proprietor: CANON KABUSHIKI KAISHA, Tokyo (JP)
(72) Inventor: Mori, Masahiro, Tokyo (JP); Fukae, Kimitoshi, Tokyo (JP); Inoue, Yuji, Tokyo (JP)
(74) Representative: Leson, Thomas Johannes Alois, Dipl.-Ing.

(56) References cited:
- EP-A- 0 625 802
- WO-A-96/39566
- DE-U- 9 312 518
- US-A- 4 433 200
- US-A- 5 092 939

## Description

### Background of the Invention

### Field of the Invention

The present invention relates to a solar cell module which is easily fabricated, light in weight, low in price, and has an excellent structure strength.

### Related Background Art

In addition to research and development concerning a solar cell element itself, technological developments to make the solar cell element available by setting up it outdoors, for example on the ground and on the roof, have been done.

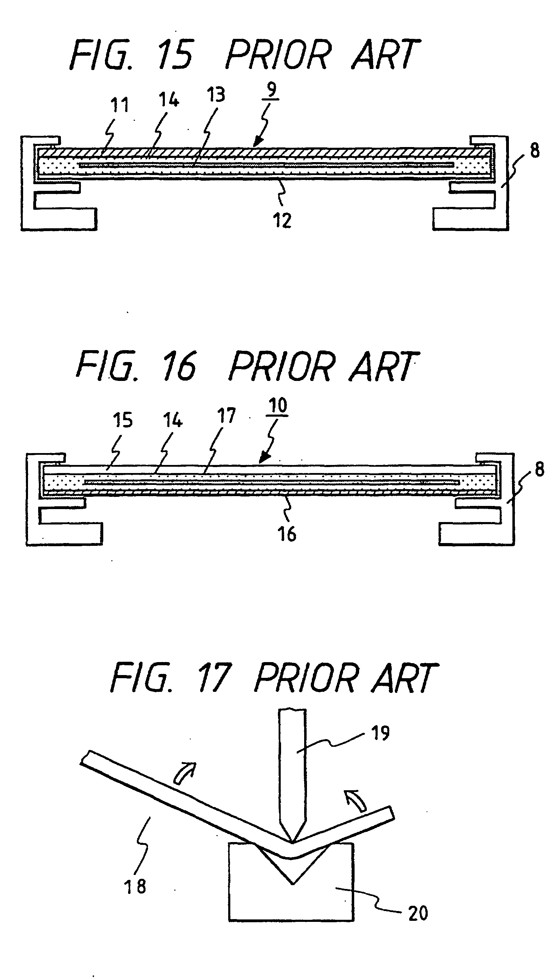

Figs. 15 and 16 are sectional views showing an example of two types of solar cell modules schematically. Referring to Figs. 15 and 16, a frame member 7 made of a material such as alminium is provided in each periphery of the solar cell modules 9 and 10, in order to reinforce the mechanical structure strength of the solar cell module and to mount it on a mounting stage.

The solar cell module illustrated in Fig. 15 employs a glass 11 on its light receiving surface side and, on the back surface side, a film 12 having a damp-proof property such as a laminated film constituted by putting an alminium film between fluororesin films. In the solar cell module, a solar cell element 13 is sealed by a translucent resin 14.

The solar cell module illustrated in Fig. 16 employs a fluororesin film 15 on its light receiving surface side and a metal reinforcement plate 16 on its back surface side. In the solar cell module, a solar cell element 17, for example, such as an amorphous silicon solar cell having a stainless substrate is sealed by a translucent resin 14. The solar cell module of this type requires no glass member on the surface for preventing fracturing of the solar cell element 17 and protecting it, as the result of using a flexible one. Therefore, the solar cell module illustrated in Fig. 16 has an advantage in that it is possible to reduce the weight thereof compared to the one illustrated in Fig. 15 using the glass 11.

US-A-4,433,200 discloses a solar cell module comprising solar cell elements being bonded on a metal plate. Two opposite sides of the metal plate are bent to form flanges by means of a roll forming operation. A conduit is provided on a shorter side of the metal plate to extend between the flanges of the longer sides of the metal plate in order to exhibit a protective function for wires. The solar cell elements are embedded within a potting material, which, in the process of the laminating process under heat, flows freely to conform the-shapes of the solar cell elements and fills the spaces therebetween. At the light incident surface of the solar cell element, a covering glass plate is provided.

As to the solar cell module of Fig. 16, a solar cell module has been proposed in Japanese Patent Application Laid-open No. 5-337138, which does not use a frame member to secure its structure strength but is made to be a box shape by bending its metal reinforcement plate at four side portions so that it can obtain a sufficient structure strength as a module. Furthermore, this solar cell module comprises no frame member so that it is very useful in that it is light in weight and it does not need a more complicated mounting step of the frame member compared to the bending working.

When the solar cell module having such solar cell element of a large area is fabricated, however, the following two problems are caused at the bending working of its metal reinforcement member at the four side portions.

### (Problem 1)

First of all, a bending working for the conventional solar cell module will be described below.

In the bending working for the conventional solar cell module, a bending working machine for a thin steel plate is used. Fig. 17 is a sectional view showing schematically the situation that a solar cell module 18 is being subjected to the bending working using this bending working machine for a thin steel plate. At the bending working, an upper edge 19 travels downward whereby according to a mold 20 the solar cell module 18 is bent in the arrow direction.

Here, as is understood from the structure of the foregoing bending working machine for a thin steel plate and the mechanism of the bending working, the upper edge 18 of the bending working machine for a thin steel plate and the mold 20 must have a larger length than that of a worked portion of the solar cell module which is to be a worked body (the length in a perpendicular direction to a drawing of Fig. 17). For this reason, when a solar cell module of a large area having a length of 3 m or more is worked, a large-sized bending working machine for a thin steel plate is required, which has an upper edge and mold having lengths more than 3 m and is capable of applying a very high pressure.

### (Problem 2)

Furthermore, when a shorter side of the metal reinforcement plate of the foregoing solar cell module is bent, the solar cell module is raised upward at 45 degrees to the horizontal at the working of the bending angle 90 degrees. Therefore, a large space drawn by a circle of a radius of 3 m from this side of the bending working machine of a thin steel plate to the upward direction is required. Moreover, since it is impossible to hold the raised solar cell module by one worker, at least two workmen for this working are necessary.

The present invention is to solve the foregoing problems 1 and 2.

### SUMMARY OF THE INVENTION

An object of the present invention is to provide an improved solar cell module and a method for manufacturing the same which solve the aforementioned problems (1) and (2), respectively.

This object is achieved by the features set forth in the independent claims 1 and 26, respectively. Preferred embodiments are set forth in the dependent claims 2 to 25, and 27 to 29, respectively.

### BRIEF DESCRIPTION OF THE DRAWINGS

Fig. 1 is a perspective view showing an example of a solar cell module according to an embodiment of the present invention;
Fig. 2 is a section view of the solar cell module shown in Fig. 1;
Fig. 3 is a section view showing a situation that the solar cell module is worked by a roller mold machine according to the present invention;
Fig. 4 is a section view showing a situation that the solar cell module according to the present invention is bent gradually;
Fig. 5 is a section view showing a solar cell element used in the solar cell module according to example 1;
Fig. 6 is a plan view showing the solar cell element used in the solar cell module according to the example 1;
Fig. 7 is a section view showing a situation that a current collecting grid is arranged in the solar cell module according to the example 1;
Fig. 8 is a plan view showing a situation that the solar cell elements are connected in series in the solar cell module according to the example 1;
Fig. 9 is a plan view showing a back wiring surface in the solar cell module according to the example 1;
Fig. 10 is a perspective view showing the solar cell module according to the example 1;
Fig. 11 is a section view showing the solar cell module according to the example 1;
Fig. 12 is a section view showing a frame member used in the solar cell module according to the example 1;
Fig. 13 is a perspective view showing a solar cell module of example 2 according to the present invention;
Fig. 14 is another perspective view showing the solar cell module according to the example 3 of the present invention;
Fig. 15 is a section view showing an example of a conventional solar cell module;
Fig. 16 is a section view showing another example of the conventional solar cell module; and
Fig. 17 is a section view showing a situation that the conventional solar cell module using a bending working machine for a thin steel plate.

### DETAILED DESCRIPTION OF THE PREFERRED EMBODIMENTS

In a bending working for a solar cell module formed integrally with a metal reinforcement plate, the present invention does not use a conventional bending working machine for a thin steel plate shown in Fig. 17 but uses a roller mold machine. A roller mold machine is one which performs the bending working gradually transporting a worked body held between a pair of rotating rollers.

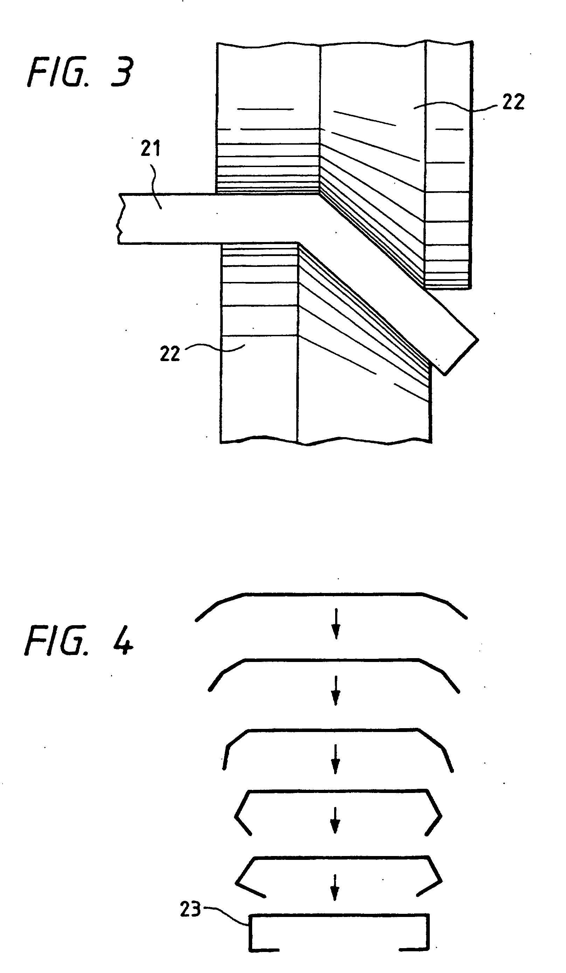

Figs. 3 and 4 are a schematical section view for explaining the bending working by the roller mold machine. As is clear from Fig. 3, it is proved that solar cell module 21 is bent by making a pair of rollers 22 holding the module 21 to be a desired sha

As is clear from Fig. 4, it is also proved a solar cell module 23 passes through a plurality o stations having a pair of rollers whereby the module 23 is bent step by step so as to be made into a desired final shape.

As is understood from a structure of the foregoing roller mold machine and its working mechanism, a size of the roller mold machine is determined dominantly from the number of the stations in the pair of the rollers, and the number of the stations is determined dominantly from a shape of a bending portion, for example, its complexity and a magnitude of a bending angle.

In the working for the solar cell module 23 having a final cross section of a U-like shape, shown in Fig. 4, the number of the stages is 6, and the roller mold machine having a length of about 1.8 m will do well. Specifically, if a length of the module is 3 m or more and the module is worked to the aforementioned working shape, the length of the roller mold machine may be 1.8 m, so that a size of the roller mold machine can be greatly reduced compared to the above described conventional bending working machine for a thin steel plate.

If the bending working machine for a thin steel plate is used, an operation from a setting of a solar cell module to a bending working must be performed repeatedly at least four times. For this reason, it takes time and a labor cost for these operations increases a fabrication cost of the module. On the contrary, according to the present invention, one worker can pass the module through the roller mold machine so that the bending working for two facing sides is completed in a moment.

A direction to bend the two facing sides may be inverse to the light receiving surface, or vice versa. Furthermore, each of the two facing sides may be bent in an inverse direction to each other. As shown in Fig. 4, by bending the module twice, its strength is increased. These bending workings can be done easily by the roller working machine.

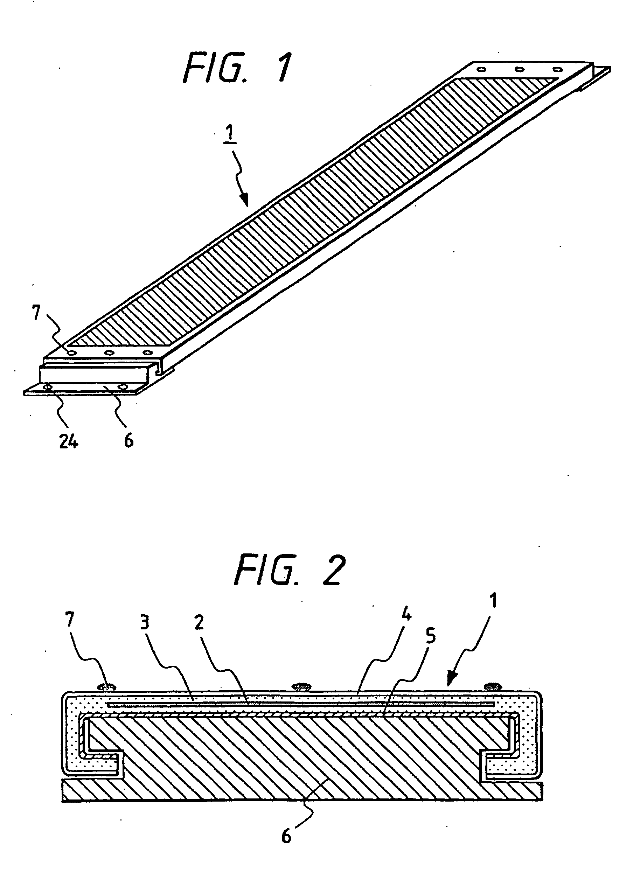

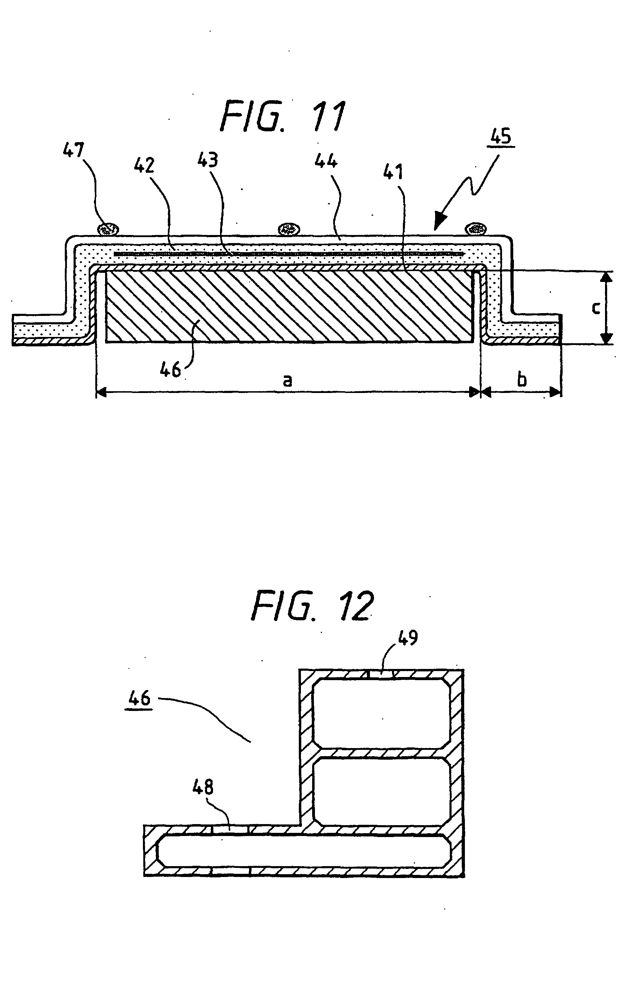

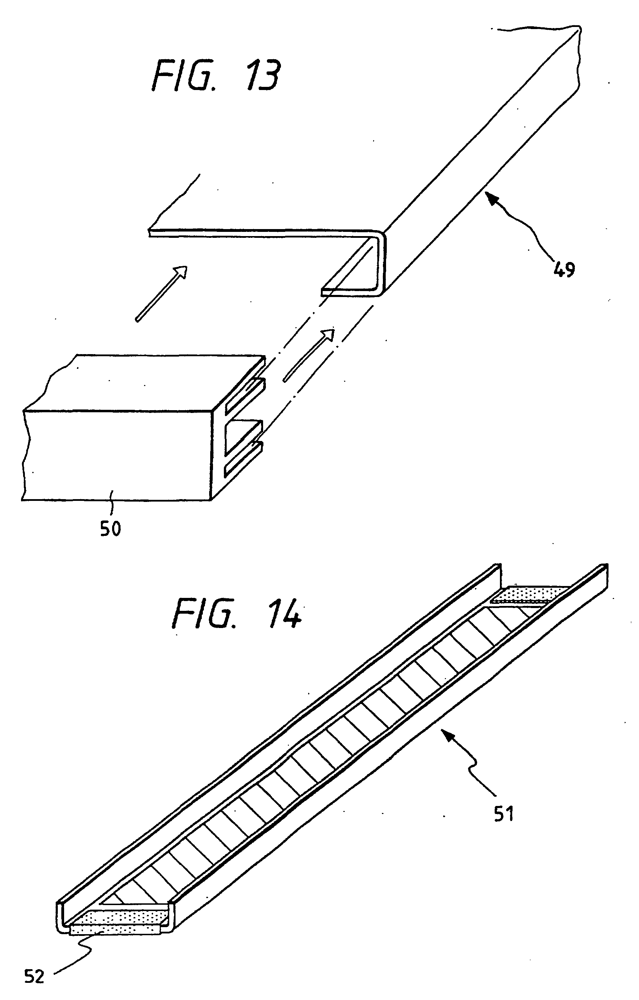

Next, a reinforcement member 6 is fitted to the shorter sides of the module. The reinforcement member 6 is made of alminium which has an L-shaped section as shown in Fig. 12 which is not in accordance with the present invention, an E-shaped section as shown in Fig. 13, or a U-shaped section as shown in Fig. 14. The frame member 6 may be secured to the solar cell module 1 with a drill vis 7, otherwise, with a rivet, a welding, or a deposition. Compared to the conventional module in which a frame member is fitted to four sides, the number of the members is reduced, and the working for attachment of the members is easier. The frame member 6 has a shape corresponding to the cross section of the module as shown in Fig. 2. This prevents the invasion of wind and rain to the back surface of the module.

The solar cell module of the present invention fabricated in such manner can have a sufficient structure strength as a unit, and could be fabricated inexpensively.

This is because the solar cell module is made using the roller mold machine, and the structure strength of the module is increased by means for providing the frame member, considering the difficulty of the bending working for the short sides.

### (Constitution of Module)

Referring to Fig. 2, a constitution of the solar cell module 1 of the present invention will be described.

The solar cell module 1 of the present invention has a solar cell element 2 sealed by a translucent resin 3, a translucent resin film 4 on the surface of a light receiving side, and a metal plate 5, which is subjected to the foregoing working, on the back surface of the light receiving side. These are laminated by adhesions. An insulating film may be provided between the metal plate 5 and the element 2. In order to increase an anti-scratch property, glass non-woven cloth may be disposed between the film and the element 2.

### (Solar Cell Element)

The solar cell element used in the solar cell module according to the present invention is not limited to the specified kinds. However, a solar cell element having the flexibility should be preferable. Particularly, an amorphous silicon solar cell formed on a stainless substrate is preferably mentioned.

By using the solar cell element having the flexibility, even if a force is applied to the solar cell module when it is bent by the roller mold machine etc., and the module is worked, the solar cell element is never destroyed.

### (Translucent Resin Film)

The translucent resin film used on the light receiving surface of the solar cell module according to the present invention preferably has a weather resisting property, and for example, a fluororesin film may be suitable for it.

Furthermore, when the film is stretched by the bending working, the fluororesin film is preferably extendable in more than 250 % in order that breakages and cracks are not caused in the film. When it is less than 250 %, there is a possibility that cracks of the film might be caused at the bending working of the solar cell.

### (Translucent Resin)

As the translucent resin for sealing used in the solar cell module according to the present invention may be, for example, ethylene-vinyl acetate copolymer (EVA), EEA, polyvinyl butyral, and silicone resin and the like.

### (Metal Reinforcement Plate)

The metal reinforcement plate used in the solar cell module according to the present invention should be preferable, excellent in a weather resisting property and a bending working property, and has been proved that it has a long term reliability as an. ordinary metal roof material. For example, it may be a galvanized sheet, a steel plate having a weather resisting material such as fluororesin or vinyl chloride on the galvanized steel, and a stainless steel plate and the like.

### (Insulating Film)

The insulating film used in the solar cell module according to the present invention may be PET (polyethylene terephthalate) and a nylon film and the like.

### EXAMPLES

### (Example 1)

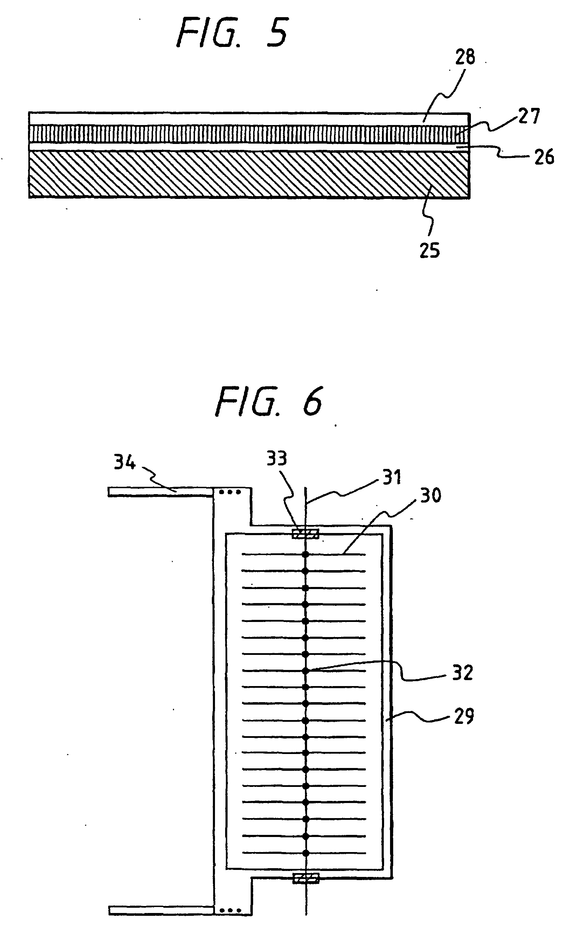

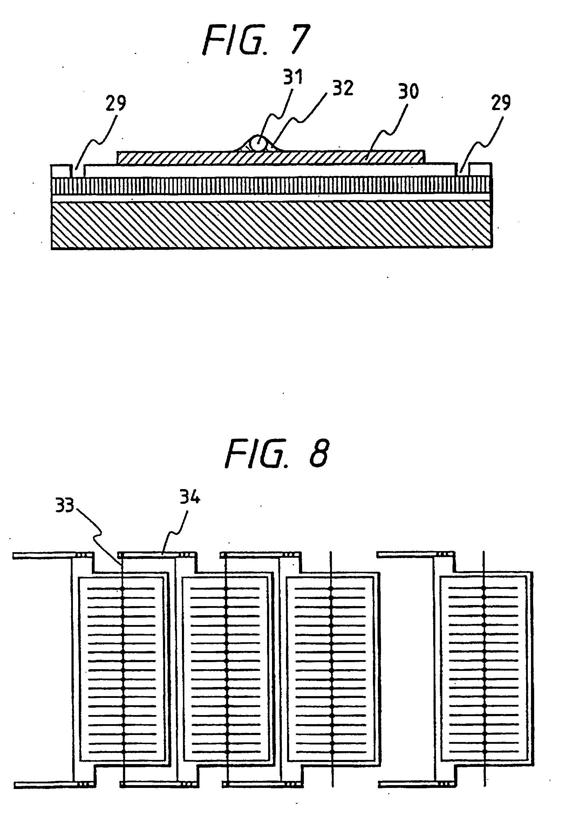

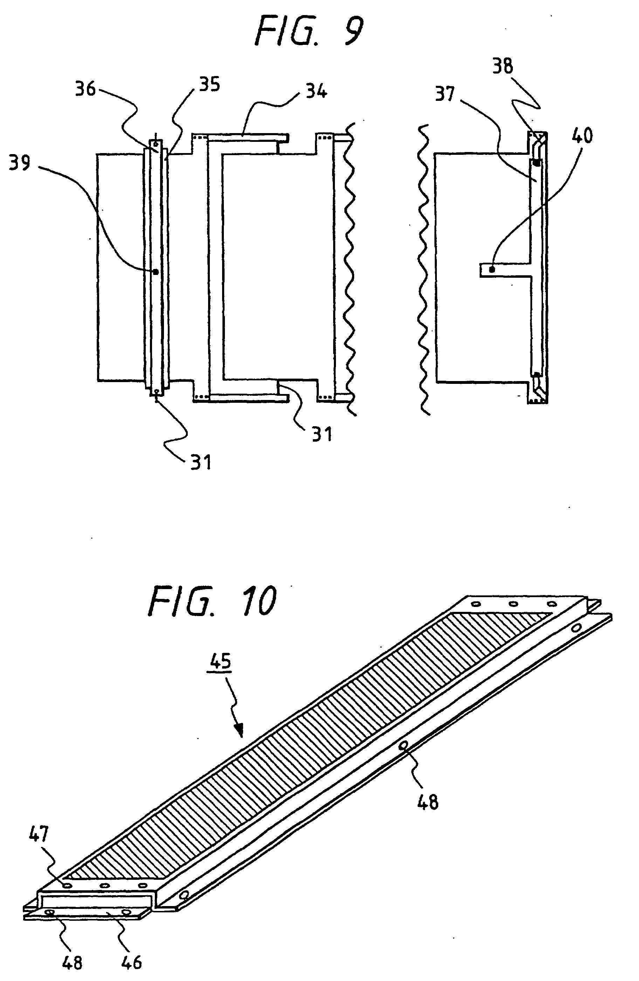

(1) First of all, the solar cell having the constitution shown in Fig. 5 was made. On a roll shaped stainless substrate 25 having a thickness of 0.1 mm, an alminium thin film 26 having a thickness of 500 nm, an amorphous silicon semiconductor layer 27 having a nip junction, and an ITO thin film 28 having a thickness of 80 nm are sequentially laminated.
(2) Subsequently, the stainless substrate 25 is press-cut punched to a size of 30 cm x 9 cm so that a slab having a shape shown in Fig. 6 is formed. In order to prevent a short circuit of a cutting surface, a portion denoted by a reference numeral 29 is formed by removing partially the ITO thin film which is located at the outer periphery of the substrate 25. Electrodes 30 are formed by a silver paste (Dupont 5007), and a bus bar 31 made of a tin-plated copper wire is adhered by a silver ink 32 (Emerson & Cumming C-220) to form an upper electrode.
   Furthermore, a copper foil 34 is welded to the stainless of the back surface to form a lower electrode. Reference numeral 33 is a polyimide tape to prevent the short circuit. Fig. 7 is a cross-sectional of view of Fig. 6.
(3) The slabs constituting the solar cell are connected in series by soldering the tin-plated copper wire 31 with the copper foil 34 of the adjacent slab as shown in Fig. 8, and, thirty slabs are connected in series.
(4) Terminals to fetch a power to the outside are provided on the back surface of the slab as shown in Fig. 9. The upper electrode 31 is connected to a copper tab 36, and the copper tab 36 is adhered to the substrate via the insulating tape. The lower electrode welds directly the copper tab 38 to the substrate, and the copper tab 37 is connected by soldering. The power is fetched through the terminals 39 and 40.
(5) On the surface of a galvanized sheet which is 0.4 mm thick, EVA 42, the solar cell element 43 connected in series in the foregoing paragraph (4), EVA 42, and a fluororesin film 44 are sequentially laminated, and the EVA was fused at a temperature of 150 °C using a vacuum laminater so that they were adhered and laminated to each other so that the solar cell module is formed. In the solar cell module, as the EVA, a sheet-shaped EVA of 900 µm thick was used, and a non-stretched ethylene-tetraethylene copolymer fluororesin film (AFLEX manufactured by Asahi Glass Co., Ltd.) of 50 µm was used as the fluororesin film. The portions of the EVA and the fluororesin film, which protrude from the metal reinforcement plate, were cut. The size of the solar cell module was made to be 470 mm x 3000 mm.
(6) The planar solar cell module prepared in the paragraph (5) was bent by the roller mold machine to form the cell module is in a hat-shaped in a cross-section as shown in Fig. 11. At this time, concerning the dimensions of the portions a, b, and c shown in Fig. 11, the portion a is 350 mm, the portion b is 30 mm, and the portion c is 30 mm.
(7) A frame member is fixed to the short sides of the solar cell module which has been subjected to the bending working of the paragraph (6). A sectional view of the solar cell module at this state was shown in Fig. 12. The frame member is manufactured from a drawing working material of aluminium. A screw hole 49 for fixing the frame member to the module by a screw is formed on its upper portion.

The solar cell module of this example shown in Fig. 10 is fabricated in the above described manner and is not in accordance with the present invention.

This solar cell module is fitted to a mounting stage by a bolt and a nut and the like, utilizing a fitting hole 48 formed in the frame member and the metal reinforcement plate itself shown in Fig. 10.

### (Example 2)

The solar cell module of this example was to bent to be formed in a U-shaped cross section as shown in Fig. 13. Then, the solar cell module was fitted to a frame member made of aluminium using a silicon sealant agent as an adhesive agent.

The solar cell module 49 of this example was fabricated in the similar manner to the example 1. As shown in Fig. 13, the longer sides thereof were bent by the roller mold machine so that they have a U-shaped cross section.

The silicon sealant agent was injected to a cut portion of the frame member 50, and the frame member 50 was fitted to the solar cell module 49 as shown in the arrow line of Fig. 13.

As in this example, the end portion of the short side of the solar cell module 49 was inserted into the cut portion of the frame member 50, so that separations at an interface between the metal reinforcement plate and the EVA resin never occurred. The reliability of the solar cell module 49 was greatly increased.

Furthermore, since drill screws are not used in this solar cell module, its exterior view is excellent.

### (Example 3)

The solar cell module of this example 3 was designed so that it possesses a shape suitable for "a tile roofing" which is an existing execution method for a roof material.

A perspective view of the solar cell module is shown in Fig. 14. As is understood from Fig. 14, in the solar cell module of this example, the long sides thereof were bent upward, and in the short sides thereof, the frame member was provided, which was formed by bending a steel material.

The solar cell module 51 of this example was fabricated in the similar manner to the example 1. As shown in Fig. 14, the long sides of the solar cell module 51 were bent by the roller mold machine so that they were bent upward.

The frame member 52 was formed by performing the bending working to bend a steel plate which is 0.4 mm thick, coated with a stainless, so that it has a U-shaped cross section. The frame member 52 was fitted to a planar plate portion at the center of the module using a silicon sealant agent as an adhesive agent.

The solar cell module of this example was designed so that it possesses a shape suitable for "a tile roofing" which is an execution method for a roof material. Thus, the solar cell module of this example having the foregoing shape was set up on the roof. Therefore, a sufficient structure strength could be secured with the foregoing constitution.

In a solar cell module in which a solar cell element is mounted on a metal plate, two opposite sides of the metal plate are bent, and a reinforcement member is provided on at least one of the remaining two sides other than the two opposite sides. Thus, the solar cell module of the present invention, which is manufactured easily, light in weight, and inexpensive, can be provided. Furthermore, the solar cell module of the present invention is excellent in a structure strength as a module unit.

## Claims

1. A solar cell module comprising:
a solar cell element (2; 43);
a rectangular metal plate (5; 41) having two opposing longer sides and two opposing shorter sides;
a translucent resin (3; 42); and
a translucent resin film (4; 44);
wherein said solar cell element is sealed by said resin and is sandwiched between said rectangular metal plate and said resin film which covers a light incident surface of said solar cell element;
wherein said two opposing longer sides of said rectangular metal plate are bent to form bent portions;
wherein all of Said bent portions of said rectangular metal plate are covered with said resin film on a side of said rectangular metal plate on which said solar cell element is mounted;
wherein a reinforcement member (6; 50; 52) having a cross-section with projecting parts having two opposing surfaces is fitted on at least one of said two opposing shorter sides of said rectangular metal plate such that said rectangular metal plate is engaged between the two opposing surfaces of the projecting parts of said reinforcement member.

2. A solar cell module according to claim 1,
wherein said reinforcement member (6; 50; 52) sandwiches said rectangular metal plate (5) and said resin film (4) which covers said rectangular metal plate in an E-shaped section (50) or U-shaped section (6; 52) at the shorter sides of the module.

3. A solar cell module according to claim 1, wherein said two opposite sides are bent in a direction opposed to the light receiving surface of said solar cell element.

4. A solar cell module according to claim 1, wherein said two opposite sides are bent in a direction toward the light receiving surface of said solar cell element.

5. A solar cell module according to claim 1, wherein one of said two opposite sides is bent in a direction opposed to a light receiving surface and the other of said two opposite sides is bent in a direction toward the light receiving surface of said solar cell element.

6. A solar cell module according to claim 1, wherein the cross-section with projecting parts of said reinforcement member is a portion of the reinforcement member for fitting said metal plate.

7. A solar cell module according to claim 6, wherein a sealant is provided in said fitting portion.

8. A solar cell module according to claim 1, wherein said metal plate and said reinforcement member are connected by a screw.

9. A solar cell module according to claim 1, wherein said metal plate (5) and said reinforcement member (6) are connected by a rivet (7).

10. A solar cell module according to claim 1, wherein said metal plate and said reinforcement member are connected by welding.

11. A solar cell module according to claim 1, wherein said metal plate and said reinforcement member are connected by adhering.

12. A solar cell module according to claim 1, wherein said reinforcement member is made of a drawn aluminum material.

13. A solar cell module according to claim 6, wherein said reinforcement member is made of a U-shaped steel plate.

14. A solar cell module according to claim 1, wherein said solar cell module comprises, being sequentially laminated on said metal plate, an insulating film, said solar cell element (2; 43), a filler material as said translucent resin (3; 42), and a surface protection film as said translucent resin film (4; 44).

15. A solar cell module according to claim 1, wherein said metal plate is a galvanized steel plate or a stainless steel plate.

16. A solar cell module according to claim 14, wherein said insulating film is a polyethylene terephthalate film or a nylon film.

17. A solar cell module according to claim 14, wherein a filler material as said translucent resin (3; 42) is further provided between said insulating film and said metal plate.

18. A solar cell module according to claim 14, wherein a filler material as said translucent resin (3; 42) is further provided between said insulating film and said solar cell element.

19. A solar cell module according to claim 14, wherein said filler material is selected from ethylene-vinyl acetate copolymer, ethylene-ethyl acrylate copolymer, polyvinyl butyral, and silicone resin.

20. A solar cell module according to claim 17, wherein said filler material is selected from ethylene-vinyl acetate copolymer, ethylene-ethyl acrylate copolymer, polyvinyl butyral, and silicone resin.

21. A solar cell module according to claim 18, wherein said filler material is selected from ethylene-vinyl acetate copolymer, ethylene-ethyl acrylate copolymer, polyvinyl butyral, and silicone resin.

22. A solar cell module according to claim 1, wherein said solar cell element is flexible.

23. A solar cell module according to claim 1, wherein said solar cell element is made of a non-single crystal semiconductor.

24. A solar cell module according to claim 23, wherein said solar cell element is made of an amorphous semiconductor formed on a stainless steel substrate.

25. A solar cell module according to claim 1, wherein said reinforcement member is a bent metal plate.

26. A method of manufacturing a solar cell module according to claim 1 comprising the steps of:
laminating successively a rectangular metal plate having two opposing longer sides and two opposing shorter sides, a solar cell element sealed in a translucent resin and a resin translucent film, wherein said translucent resin film covers a light incident surface of said solar cell element;
bending two opposite sides of said solar cell module which correspond to said two opposing longer sides of said rectangular metal plate by a pair of rotating rollers to form bent portions,
wherein all of said bent portions are covered with said translucent resin film on a side of said rectangular metal plate on which said solar cell element is mounted; and
fitting a reinforcement member which is an integral member having a cross-section with projecting parts having two opposing surfaces to at least one of the two remaining sides which correspond to said two opposing shorter sides of said rectangular metal plate such that said at least one of said shorter sides of said rectangular metal plate is engaged between and in contact with the two opposing surfaces of the projecting parts of the reinforcement member.

27. A method of manufacturing a solar cell module according to claim 26,
wherein said reinforcement member sandwiches said rectangular metal plate and said translucent resin film which covers said rectangular metal plate in an E-shaped section or U-shaped section at the shorter sides of the module.

28. A method of manufacturing a solar cell module according to claim 26, wherein said reinforcement member is formed by bending a metal plate.

29. A method of manufacturing a solar cell module according to claim 26, wherein said laminating step is conducted by a vacuum laminator.

## Patentansprüche

1. Solarzellenmodul, das umfasst:
ein Solarzellenelement (2; 43);
eine rechteckige Metallplatte (5; 41) mit zwei einander gegenüberliegenden längeren Seiten und zwei einander gegenüberliegenden kürzeren Seiten;
ein lichtdurchlässiges Harz (3; 42); und
ein lichtdurchlässiger Harzfilm (4; 44);
wobei das Solarzellenelement durch das Harz versiegelt ist und sandwitchartig zwischen der rechteckigen Metallplatte und dem Harzfilm, welcher eine lichteinfallende Oberfläche des Solarzellenelementes bedeckt, eingeschlossen ist;
wobei die zwei einander gegenüberliegenden längeren Seiten der rechteckigen Metallplatte gebogen sind, um gebogene Teile zu bilden;
wobei alle gebogenen Teile der rechteckigen Metallplatte auf einer Seite der rechteckigen Metallplatte, auf welcher das Solarzellenelement montiert ist, mit dem Harzfilm bedeckt sind;
wobei ein Verstärkungselement (6; 50; 52) mit einem Querschnitt mit vorstehenden Teilen, die zwei einander gegenüberliegende Oberflächen aufweisen, auf wenigstens eine der zwei gegenüberliegenden kürzeren Seiten der rechteckigen Metallplatte eingepasst ist, so dass die rechteckige Metallplatte zwischen den zwei gegenüberliegenden Oberflächen der vorstehenden Teile des Verstärkungselementes zum liegen kommt.

2. Solarzellenmodul gemäß Anspruch 1, wobei das Verstärkungselement (6; 50; 52) die rechteckige Metallplatte (5) und den Harzfilm (4), welcher die rechteckige Metallplatte in einem E-förmigen Abschnitt (50) oder U-förmigen Abschnitt (6; 52) an den kürzeren Seiten des Moduls bedeckt, sandwichartig einschließt.

3. Solarzellenmodul gemäß Anspruch 1, wobei die zwei gegenüberliegenden Seiten in einer Richtung gebogen sind, die der Lichtempfangsoberfläche des Solarzellenelementes entgegengesetzt ist.

4. Solarzellenmodul gemäß Anspruch 1, wobei die zwei gegenüberliegenden Seiten in einer Richtung zu der Lichtempfangsoberfläche des Solarzellenelementes gebogen sind.

5. Solarzellenmodul gemäß Anspruch 1, wobei eine der zwei entgegengesetzten Seiten in einer Richtung gebogen ist, die einer Lichtempfangsoberfläche entgegengesetzt ist und die andere der zwei entgegengesetzten Seiten in einer Richtung zu der Lichtempfangsoberfläche des Solarzellenelementes gebogen ist.

6. Solarzellenmodul gemäß Anspruch 1, wobei der Querschnitt mit zwei vorstehenden Teilen des Verstärkungselementes ein Teil des Verstärkungselementes zum Einpassen der Metallplatte ist.

7. Solarzellenmodul gemäß Anspruch 6, wobei ein Versiegelungsmittel in dem Einpassteil vorgesehen ist.

8. Solarzellenmodul gemäß Anspruch 1, wobei die Metallplatte und das Verstärkungselement durch eine Schraube verbunden sind.

9. Solarzellenmodul gemäß Anspruch 1, wobei die Metallplatte (5) und das Verstärkungselement (6) durch eine Niete (7) verbunden sind.

10. Solarzellenmodul gemäß Anspruch 1, wobei die Metallplatte und das Verstärkungselement durch Schweißen verbunden sind.

11. Solarzellenmodul gemäß Anspruch 1, wobei die Metallplatte und das Verstärkungselement durch Kleben verbunden sind.

12. Solarzellenmodul gemäß Anspruch 1, wobei das Verstärkungselement aus einem gezogenen Aluminiummaterial hergestellt ist.

13. Solarzellenmodul gemäß Anspruch 6, wobei das Verstärkungselement aus einer U-förmigen Stahlplatte hergestellt ist.

14. Solarzellenmodul gemäß Anspruch 1, wobei das Solarzellenmodul, das sequentiell auf der Metallplatte laminiert ist, einen Isolierungsfilm, das Solarzellenelement (2; 43), ein Füllstoffmaterial als das lichtdurchlässige Harz (3; 42), und einen Oberflächenschutzfilm als den lichtdurchlässigen Harzfilm (4; 44) umfasst.

15. Solarzellenmodul gemäß Anspruch 1, wobei die Metallplatte eine galvanisierte Stahlplatte oder eine Platte aus rostfreiem Stahl ist.

16. Solarzellenmodul gemäß Anspruch 14, wobei der Isolierungsfilm ein Polyethylenterephthalatfilm oder ein Nylonfilm ist.

17. Solarzellenmodul gemäß Anspruch 14, wobei ein Füllstoffmaterial als das lichtdurchlässige Harz (3; 42) ferner zwischen dem Isolierungsfilm und der Metallplatte vorgesehen ist.

18. Solarzellenmodul gemäß Anspruch 14, wobei ein Füllstoffmaterial als das lichtdurchlässige Harz (3; 42) ferner zwischen dem Isolierungsfilm und dem Solarzellenelement vorgesehen ist.

19. Solarzellenmodul gemäß Anspruch 14, wobei das Füllstoffmaterial aus Ethylen/Vinylacetat-Copolymer, Ethylen/Ethylacrylat-Copolymer, Polyvinylbutyral, und Siliconharz ausgewählt ist.

20. Solarzeilenmodul gemäß Anspruch 17, wobei das Füllstoffmaterial aus Ethylen/Vinylacetat-Copolymer, Ethylen/Ethylacrylat-Copolymer, Polyvinylbutyral, und Siliconharz ausgewählt ist.

21. Solarzellenmodul gemäß Anspruch 18, wobei das Füllstoffmaterial aus Ethylen/Vinylacetat-Copolymer, Ethylen/Ethylacrylat-Copolymer, Polyvinylbutyral und Siliconharz ausgewählt ist.

22. Solarzellenmodul gemäß Anspruch 1, wobei das Solarzellenelement flexibel ist.

23. Solarzellenmodul gemäß Anspruch 1, wobei das Solarzellenelement aus einem Nicht-Einkristall Halbleiter hergestellt ist.

24. Solarzellenmodul gemäß Anspruch 23, wobei das Solarzellenelement aus einem amorphen Halbleiter, der auf einem rostfreien Stahlsubstrat gebildet ist, hergestellt ist.

25. Solarzellenmodul gemäß Anspruch 1, wobei das Verstärkungselement eine gebogene Metallplatte ist.

26. Verfahren zum Herstellen eines Solarzellenmoduls gemäß Anspruch 1, das die folgenden Schritte umfasst:
aufeinanderfolgendes Laminieren einer rechteckigen Metallplatte mit zwei gegenüberliegenden längeren Seiten und zwei gegenüberliegenden kürzeren Seiten, eines Solarzellenelementes, das in einem lichtdurchlässigen Harz versiegelt ist, und eines lichtdurchlässigen Harzfilms, wobei der lichtdurchlässige Harzfilm eine Lichteinfallsoberfläche des Solarzellenelementes bedeckt;
Biegen der zwei gegenüberliegenden Seiten des Solarzellenmoduls, welches den zwei gegenüberliegenden längeren Seiten der rechteckigen Metallplatte entsprechen, durch ein Paar von rotierenden Walzen, um gebogene Teile zu bilden,
wobei alle gebogenen Teile mit dem lichtdurchlässigen Harzfilm auf einer Seite der rechteckigen Metallplatte, auf welcher das Solarzellenelement montiert ist, bedeckt sind;
und
Einpassen eines Verstärkungselementes, welches eine integrales Element, das einen Querschnitt mit vorstehenden Teilen besitzt, die zwei gegenüberliegende Oberflächen zu wenigstens einem der zwei verbleibenden Seiten aufweisen, welche den zwei gegenüberliegenden kürzeren Seiten der rechteckigen Metallplatte entsprechen, so dass die wenigstens eine der kürzeren Seiten der rechteckigen Metallplatte dazwischen zum liegen kommt und in Kontakt mit den zwei gegenüberliegenden Oberflächen der vorstehenden Teile des Verstärkungselementes ist.

27. Verfahren zum Herstellen eines Solarzellenmoduls gemäß Anspruch 26,
wobei das Verstärkungselement die rechteckige Metallplatte und den lichtdurchlässigen Harzfilm, welcher die rechteckige Metallplatte in einem E-förmigen Abschnitt oder U-förmigen Abschnitt an den kürzeren Seiten des Moduls bedeckt, sandwichartig einschließt.

28. Verfahren zum Herstellen eines Solarzellenmoduls gemäß Anspruch 26, wobei das Verstärkungselement gebildet wird, in dem eine Metallplatte gebogen wird.

29. Verfahren zum Herstellen eines Solarzellenmoduls gemäß Anspruch 26, wobei der Laminierungsschritt durch einen Vakuumlaminator ausgeführt wird.

## Revendications

1. Module de cellule solaire comprenant :
un élément de cellule solaire (2; 43) ;
une plaque métallique rectangulaire (5; 41) ayant deux côtés opposés plus longs et deux côtés opposés plus courts ;
une résine translucide (3; 42) ; et
une pellicule de résine translucide (4; 44) ;
dans lequel ledit élément de la cellule solaire est scellé au moyen de ladite résine et est compris entre ladite plaque métallique rectangulaire et ladite pellicule de résine qui couvre une surface exposée à la lumière dudit élément de cellule solaire ;
dans lequel lesdits deux côtés opposés plus longs de ladite plaque métallique rectangulaire sont courbés afin de former des portions courbées ;
dans lequel l'ensemble desdites portions courbées de ladite plaque métallique rectangulaire sont couvertes de ladite pellicule de résine sur un côté de ladite plaque rectangulaire sur laquelle ledit élément de cellule solaire est fixé ;
dans lequel un élément de renforcement (6; 50; 52) ayant une section transversale présentant des parties en saillie ayant deux surfaces opposées est fixé sur au moins un desdits deux côtés opposés plus courts de ladite plaque métallique rectangulaire de façon à ce que ladite plaque métallique rectangulaire soit comprise entre les deux surfaces opposées des parties en saillie dudit élément de renforcement.

2. Module de cellule solaire selon la revendication 1, dans lequel ledit élément de renforcement (6; 50; 52) prend en sandwich ladite plaque métallique rectangulaire (5) et ladite pellicule de résine (40) qui couvre ladite plaque métallique rectangulaire dans une section en E (50) ou une section en U (6; 52) sur les côtés plus courts du module.

3. Module de cellule solaire selon la revendication 1, dans lequel lesdits deux côtés opposés sont courbés dans une direction opposée à la surface exposée à la lumière dudit élément de cellule solaire.

4. Module de cellule solaire selon la revendication 1, dans lequel lesdits deux côtés opposés sont courbés vers la surface exposée à la lumière dudit élément de cellule solaire.

5. Module de cellule solaire selon la revendication 1, dans lequel un desdits deux côtés opposés est courbé dans une direction opposée à la surface exposée à la lumière et le second desdits deux côtés opposés est courbé vers la surface exposée à la lumière dudit élément de cellule solaire.

6. Module de cellule solaire selon la revendication 1, dans lequel la section transversale présentant des parties en saillie dudit élément de renforcement est une portion de l'élément de renforcement pour l'ajustement de ladite plaque métallique.

7. Module de cellule solaire selon la revendication 6, dans lequel un agent d'étanchéité est fourni dans ladite portion d'ajustement.

8. Module de cellule solaire selon la revendication 1, dans lequel ladite plaque métallique et ledit élément de renforcement sont reliés au moyen d'une vis.

9. Module de cellule solaire selon la revendication 1, dans lequel ladite plaque métallique (5) et ledit élément de renforcement (6) sont reliés au moyen d'un rivet (7).

10. Module de cellule solaire selon la revendication 1, dans lequel ladite plaque métallique et ledit élément de renforcement sont reliés par soudure.

11. Module de cellule solaire selon la revendication 1, dans lequel ladite plaque métallique et ledit élément de renforcement sont reliés par collage.

12. Module de cellule solaire selon la revendication 1, dans lequel ledit élément de renforcement est constitué d'un matériau d'aluminium étiré.

13. Module de cellule solaire selon la revendication 6, dans lequel ledit élément de renforcement est constitué d'une plaque d'acier en U.

14. Module de cellule solaire selon la revendication 1, dans lequel ledit module de cellule solaire comprend, séquentiellement laminés sur ladite plaque métallique, une pellicule isolante, ledit élément de cellule solaire (2; 43), un matériau de charge tel que ladite résine translucide (3; 42) et une pellicule de protection de la surface telle que ladite pellicule de résine translucide (4; 44).

15. Module de cellule solaire selon la revendication 1, dans lequel ladite plaque métallique est une plaque en acier galvanisé ou une plaque en acier inoxydable.

16. Module de cellule solaire selon la revendication 14, dans lequel ladite pellicule isolante est une pellicule de téréphtalate de polyéthylène ou une pellicule de nylon.

17. Module de cellule solaire selon la revendication 14, dans lequel un matériau de charge tel que ladite résine translucide (3; 42) est en outre fourni entre ladite pellicule isolante et ladite plaque métallique.

18. Module de cellule solaire selon la revendication 14, dans lequel un matériau de charge tel que ladite résine translucide (3; 42) est en outre fourni entre ladite pellicule isolante et ledit élément de cellule solaire.

19. Module de cellule solaire selon la revendication 14, dans lequel ledit matériau de charge est choisi parmi le copolymère d'éthylène et d'acétate de vinyle, le copolymère d'éthylène et d'acrylate d'éthyle, le polyvinyle butyral et une résine de silicone.

20. Module de cellule solaire selon la revendication 17, dans lequel ledit matériau de charge est choisi parmi le copolymère d'éthylène et d'acétate de vinyle, le copolymère d'éthylène et d'acrylate d'éthyle, le polyvinyle butyral et une résine de silicone.

21. Module de cellule solaire selon la revendication 18, dans lequel ledit matériau de charge est choisi parmi le copolymère d'éthylène et d'acétate de vinyle, le copolymère d'éthylène et d'acrylate d'éthyle, le polyvinyle butyral et une résine de silicone.

22. Module de cellule solaire selon la revendication 1, dans lequel ledit élément de cellule solaire est flexible.

23. Module de cellule solaire selon la revendication 1, dans lequel ledit élément de cellule solaire est constitué de plusieurs cristaux semiconducteurs.

24. Module de cellule solaire selon la revendication 23, dans lequel ledit élément de cellule solaire est constitué d'un semi-conducteur amorphe formé sur un substrat d'acier inoxydable.

25. Module de cellule solaire selon la revendication 1, dans lequel ledit élément de renforcement est une plaque métallique courbée.

26. Procédé de production d'un module de cellule solaire selon la revendication 1 comprenant les étapes consistant à :
laminer successivement une plaque métallique rectangulaire ayant deux côtés opposés plus longs et deux côtés opposés plus courts, un élément de cellule solaire scellé dans une résine translucide et une pellicule de résine translucide, dans lequel ladite pellicule de résine translucide couvre une surface exposée à la lumière dudit élément de cellule solaire ;
courber deux côtés opposés dudit module de cellule solaire qui correspondent auxdits deux côtés opposés plus longs de ladite plaque métallique rectangulaire au moyen d'un couple de rouleaux tournants afin de former des portions courbées,
dans lequel l'ensemble desdites portions courbées sont couvertes de ladite pellicule de résine translucide sur un côté de ladite plaque métallique rectangulaire sur laquelle ledit élément de cellule solaire est fixé ; et
l'ajustement d'un élément de renforcement qui est un élément intégral ayant une section transversale présentant des parties en saillie ayant deux surfaces opposées à au moins un des deux- côtés restant qui correspondent auxdits deux côtés opposés plus courts de ladite plaque métallique rectangulaire de façon à ce qu'au moins un desdits côtés plus courts de ladite plaque métallique rectangulaire soit compris entre les deux surfaces opposées des parties en saillie de l'élément de renforcement et soit en contact avec celles-ci.

27. Procédé de production d'un module de cellule solaire selon la revendication 26, dans lequel ledit élément de renforcement prend en sandwich ladite plaque métallique rectangulaire et ladite pellicule de résine translucide qui couvre ladite plaque métallique rectangulaire dans une section en E ou une section en U sur les côtés plus courts du module.

28. Procédé de production d'un module de cellule solaire selon la revendication 26, dans lequel ledit élément de renforcement est formé en courbant une plaque métallique.

29. Procédé de production d'un module de cellule solaire selon la revendication 26, dans lequel ladite étape de laminage est effectuée au moyen d'une machine de laminage sous vide.
